# EUROPEAN PATENT APPLICATION

(11) **EP 0 590 222 A1**
(43) Date of publication of application: **06.04.1994**
(21) Application number: 92830544.0
(22) Date of filing: 30.09.1992
(51) Int. Cl.: G01D 5/14

(54) **Magnetic position sensor**

(71) Applicant: SGS-THOMSON MICROELECTRONICS S.r.l., I-20041 Agrate Brianza (Milano) (IT)
(72) Inventor: Murari, Bruno, I-20052 Monza (IT); Storti, Sandro, I-20099 Sesto San Giovanni (IT); Villa, Flavio, I-20159 Milano (IT)
(74) Representative: Cerbaro, Elena

(57) **Abstract**

For detecting the position of a magnetic element (5) having a field component (B_{Z}) zeroing in at least one point in space, typically in a plane (β), use is made of an array of elementary Hall-effect sensors (Sᵢ) aligned side by side in a direction (X) perpendicular to the field component in question and to the current (I) flowing through the elementary sensors. The elementary sensor (Sᵣ) generating a zero output voltage therefore indicates the zero position of the field component and consequently the position of the magnetic element (5) in relation to the position sensor (1), so that the outputs of the elementary sensors provide a quantized numeric code indicating the position of the magnetic element.

## Description

The present invention relates to a position sensor.

For detecting the position of an object, transducers based on various principles are currently available, some of which exploit the Hall effect, whereby, if a conductor material through which current flows in one direction is immersed in a magnetic field directed perpendicular to the current flow direction, across the sensor an electric field is observed perpendicular to both the current and the magnetic field and proportional to the strength of the magnetic field at that point.

Consequently, on known Hall-effect transducers, by measuring the difference in potential across the sensor, it is possible to determine the position of a magnetic element (e.g. a permanent magnet or magnetic circuit) whose field pattern is known.

Generally speaking, as the magnetic field of the permanent magnet or magnetic circuit employed is variable in space, currently used sensors only provide for accurately determining its position when the magnetic element is movable solely in a given straight line (normally parallel or perpendicular to the sensor). Any unpredictable component in the movement of the magnetic element therefore introduces measuring errors, thus impairing the reliability and limiting the scope of known Hall-effect transducers.

Further limitations are posed by the sensitivity of Hall-effect transducers to any misalignment of the magnetic element and sensor, and to variations in the quantities affecting the transfer constant, such as supply voltage and current, and the characteristics of the sensor (e.g. in the case of solid-state sensors, carrier mobility in turn dependent on temperature). As a result, known transducers involve mechanical alignment, electrical calibration, and highly complex circuitry for compensating for variations in operating conditions (e.g. in temperature), which provisions, however, do not always succeed in achieving the desired accuracy and reliability of the transducer.

It is an object of the present invention to provide a position sensor designed to overcome the aforementioned drawbacks, and which, in particular, provides for a high degree of reliability.

According to the present invention, there is provided a position sensor as claimed in Claim 1.

In other words, for detecting the position of a magnetic element having a field component zeroing in at least one point, the sensor according to the present invention employs an array of elementary sensors for determining the zero point of the field component and generating directly at the output a numeric code indicating the zero point position.

A preferred non-limiting embodiment of the present invention will be described by way of example with reference to the accompanying drawings, in which:
Fig.1 shows a view in perspective of a transducer-encoder featuring the sensor according to the present invention;
Fig.2 shows a schematic cross section of the Fig.1 sensor along line II-II;
Fig.3 shows a variation of a detail on the Fig.1 transducer;
Fig.4 shows a variation of the Fig.2 sensor.

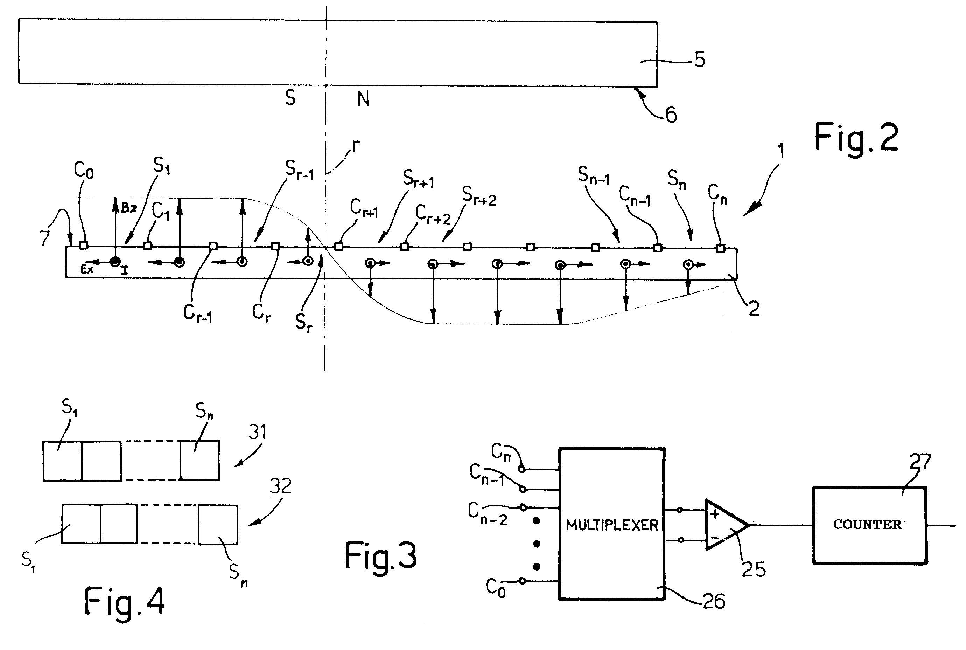

The principle underlying the present invention will be described firstly with reference to Fig.s 1 and 2 wherein number 1 indicates a solid-state type sensor formed in a chip 2 of semiconductor material (typically silicon). As shown, sensor 1 comprises a plurality of elementary sensors S₁, s₂, ... Sᵢ, Sᵢ₊₁, ... Sₙ, aligned side by side in one direction (hereinafter referred to as the X axis) and each supplied with current I directed perpendicular to the X axis, in the direction indicated by the Y axis (perpendicular to the Fig.2 plane). Each elementary sensor Sᵢ presents a pair of contacts Cᵢ₋₁, Cᵢ, also aligned along the X axis and shared respectively with the foregoing sensor Sᵢ₋₁ and the next sensor Sᵢ₊₁.

Sensor 1 is located in a magnetic field generated by a permanent magnet 5 in the form of an elongated bar, the north and south poles N and S of which are formed on face 6 facing surface 7 of sensor 1 (defining the X, Y plane and on which elementary sensors Sᵢ are arranged). Permanent magnet 5 and the line joining the N and S poles are arranged parallel to the X axis, so that permanent magnet 5 generates a magnetic field described by magnetic induction B whose component perpendicular to the current flow direction and that in which the sensor contacts are aligned (Z axis direction) is zero in one plane. In other words, for permanent magnet 5, there exists a plane β (Fig.2) in which magnetic induction component B_{Z} is zeroed; which plane, parallel to plane Y, Z, is definable by the equation X = K, where K is constant, and intercepts surface 7 along line r parallel to the Y axis. Though magnetic induction B in plane β is obviously other than zero, indeed component B_{X} is maximum, sensors Sᵢ are only sensitive to magnetic induction component B_{Z}.

In fact, due to the very nature of the Hall effect:

$\text{E = qV x B}$

so that electric field E is proportional to vectorial product I x B.

In the case in question, by virtue of contacts Cᵢ being aligned along the X axis, sensors Sᵢ are only sensitive to electric field component E_{X}; and, by virtue of current I being directed parallel to the Y axis, component E_{X} is proportional to the product of current I and magnetic induction component B_{Z}, i.e.

${\text{E}}_{\text{X}} {\text{= K₁ I B}}_{\text{Z}}$

In the example shown, by virtue of magnetic induction component B_{Z} (and therefore E_{X}) being zeroed along line r, as already stated, if Sᵣ is the sensor through which line r extends, for all the sensors S₁ ... Sᵣ₋₁ to the left of sensor Sᵣ: B_{Z} > 0 and E_{X} > 0; and, for all the sensors Sᵣ₊₁ ... Sₙ to the right of sensor Sᵣ: B_{Z} < 0 and E_{X} < 0.

Consequently, by measuring the difference in potential DVᵢ between contacts Cᵢ₋₁, Cᵢ of each sensor Sᵢ :

${\text{DV}}_{\text{i}} {\text{= V}}_{\text{i}} {\text{- V}}_{\text{i-1}} \text{< 0 when i < r and}$
${\text{DV}}_{\text{i}} {\text{= V}}_{\text{i}} {\text{- V}}_{\text{i-1}} \text{> 0 when i > r}$

When magnet 5 moves parallel to the X axis, plane β and consequently line r also move rigidly together with magnet 5, thus changing the sensor Sᵢ in which the sign of component B_{Z} and consequently the detected potential difference DVᵢ are inverted. Said sensor therefore defines, in each case, the position of plane β and, given the crossover line between the north and south poles N and S of magnet 5, the position of magnet 5 in relation to sensor 1. By detecting the point (or sensor) in which the sign of potential difference DVᵢ is inverted, it is therefore possible to determine the position of magnet 5.

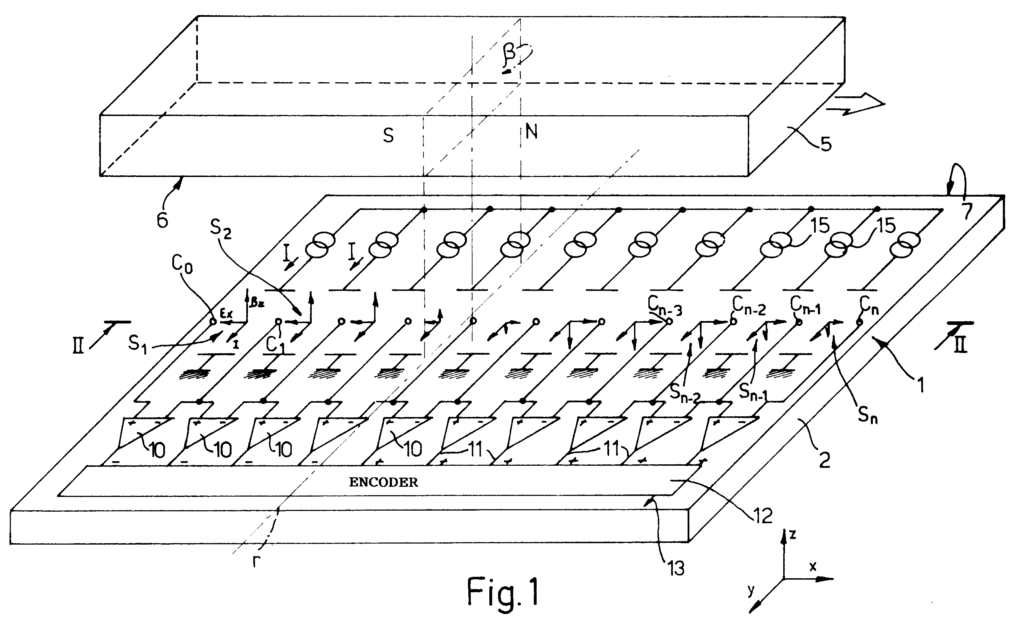

Sensor Sᵣ in which sign inversion of the potential difference occurs may be detected in various ways, one of which is shown by way of example in Fig.1, wherein each sensor Sᵢ is connected by contacts C_{i-1,} Cᵢ to a respective comparator 10, the output 11 of which generates a ground-related binary signal, the logic value of which depends on the sign of the potential difference between the contacts to which comparator 10 is connected. Outputs 11 are connected to respective inputs of an encoding circuit 12 consisting of combinatory logics and which provides for generating, at output 13, a numerical signal proportional to the position of sensor Sᵣ.

Fig.1 also shows, schematically, the current sources 15, one for each sensor Sᵢ, for generating currents I.

As shown in Fig.1, elementary sensors Sᵢ, current sources 15, comparators 10 and encoding circuit 12 are advantageously integrated in a single chip 2, more specifically, in an epitaxial layer, e.g. N type, grown on a P type substrate. As such, both contacts Cᵢ for detecting potential difference DVᵢ, and the contacts supplying current I may be formed by means of enriched N⁺ type regions (not shown), and isolation between the elementary sensors and other circuit components (and even between the elementary sensors themselves, if necessary) may be effected using normal junction isolation techniques, thus enabling the use of various standard integrated circuit manufacturing processes.

In the Fig.1 device, if l is the length of chip 2 (in direction X in which sensors Sᵢ and contacts Cᵢ are aligned) corresponding to the maximum position detection range; and w is the distance between elementary sensors Sᵢ, corresponding substantially to the width of each sensor in the same direction; then l = nw, so that the position of magnet 5 is determined discretely in n steps with an absolute resolving power of w and a relative resolving power of l/n. If, for example, l = 4 mm and w = 200 µm : n = 20, with an absolute resolving power of 200 µm and a relative resolving power of 5%.

In other words, the sensor according to the present invention provides for supplying ready-quantized position information, by virtue of field B being sampled in a finite number of points by a finite number of sensors, thus providing for numerous advantages as compared with known analog field strength measuring solutions.

Firstly, the sensor according to the present invention is insensitive to the absolute magnetic field strength (absolute magnetic induction value), and consequently to the distance of the magnetic element along the Z axis, providing the field exceeds a minimum value enabling the signal (potential difference) to be distinguished from offset and noise. As such, any nonlinearity of the field strength-distance relationship no longer requires complex logics for processing the signal generated by the sensors.

Secondly, the sensor is insensitive to any misalignment of the magnet along the X axis (lack of parallelism between the magnet and elementary sensor array), which misalignment generally results in a reduction in the strength of magnetic induction B, but has no affect on the X coordinate at which component B_{Z} is zeroed, so that the sensor only measures the variation in position along the X axis.

Thirdly, the sensor is insensitive to variations in quantities affecting the transfer constant of Hall-effect sensors, such as supply voltage and current, mobility of the carriers in the semiconductor material, and temperature (which affects the above parameters).

Fourthly, the sensor is insensitive to any nonlinearity, typical of Hall-effect sensors, between position and the detected potential difference.

All this provides, in actual use, for eliminating the need for mechanical alignment and electrical calibration, and so greatly simplifying and reducing the cost of installation, manufacture and operation (e.g. by means of appropriate processing routines) for compensating for factors which impair or at least reduce the reliability of known analog sensors. Moreover, the sensor according to the present invention is extremely stable as regards variations in temperature and supply voltage, as well as aging.

Finally, being ready-quantized, the output of the sensor according to the present invention is immediately processable using binary logics, with no conversion required, thus affording advantages in terms of circuitry and processing time. In addition to the above, the straightforward design and construction of the sensor provides for troublefree, low-cost implementation using proved standard techniques.

To those skilled in the art it will be clear that changes may be made to the sensor and relative transducer as described and illustrated herein without, however, departing from the scope of the present invention.

More specifically, the logics for detecting and processing the voltage signal generated by the elementary sensors may vary considerably as compared with those described herein. For example, as shown in Fig.3, a single comparator 25 may be employed, the two inputs of which are time-share-multiplexed to pairs of contacts Cᵢ₋₁, Cᵢ of elementary sensors Sᵢ via a multiplexer 26; and a counter 27 for counting, for example, the number of high states at the output of comparator 25, presents, for each complete scan of the sensor array, a count proportional to the position of the magnet. In this case also, comparator 25, multiplexer 26 and counter 27 may be integrated in the same chip of sensor 1.

The elementary sensors may also be mutually isolated, though, for reasons of simplicity, it is generally preferable not to do so, by virtue of the current in the sensors presenting no components along the X axis. Moreover, the adjacent contacts of adjacent elementary sensors need not necessarily be shortcircuited (especially if the elementary sensors are mutually isolated as mentioned above), in which case, each comparator may be connected solely to a respective pair of contacts; or each elementary sensor may present a first contact connected to the input of a first multiplexer, and the other contact connected to the input of a second multiplexer, with the outputs of the two multiplexers connected to the two inputs of a comparator similar to 25 in Fig.3. In this case, the increase in the number of connections is offset by greater freedom in optimization of the sensors.

In general, the elementary sensors may be aligned along any flat line lying in plane 7 of chip 2 and parallel to the path of magnet 5, e.g. a line in the form of an arc.

Also, provision may be made for more than one plurality of elementary sensors, as shown by way of example in Fig.4, which shows two pluralities 31 and 32 of elementary sensors S₁-Sₙ arranged in two parallel lines offset by w/2, w being the distance between the adjacent elementary sensors in each plurality. Both pluralities may be integrated in the same chip 2. Such an embodiment provides for enhancing resolving power, and, despite increasing (doubling) the current and the space required for integrating the sensor, the maximum dimension (the direction in which the elementary sensors in each plurality are aligned) remains unchanged. Such a solution may obviously be extended to N pluralities of sensors offset by w/N to give a resolving power of w/N and N times the current. Just how many pluralities of elementary sensors are provided is limited theoretically by the possibility of safely detecting the difference in the sign of the magnetic field component detected between two elementary sensors belonging to two different pluralities and offset by w/N.

As for the magnetic element, which does not form part of the present invention, this may be formed in any manner, providing it presents at least one magnetic field component zeroing in at least one point (preferably on a surface), and, more specifically, may consist of a permanent bar magnet, as described, or an appropriate magnetic circuit. Moreover, the useful field component (B_{Z}) and consequently the extent to which it varies about zero may be increased by providing a plate of highly permeable magnetic material in a plane parallel to plane X, Y defined by chip surface 7, and in the opposite half space to that occupied by magnet 5 (in the example shown, underneath chip 2). Alternatively, the same may be achieved using a second magnet, also located in the opposite half space to that of the first magnet, and having its south pole aligned with the north pole of the first magnet and vice versa, in which case, both magnets must move integral with each other in relation to the sensor.

## Claims

1. A position sensor (1) for detecting the position of a magnetic element (5) generating a magnetic field having at least one component (B_{Z}) zeroing in at least one point in space; characterized by the fact that it comprises at least one plurality (31; 32) of side by side elementary sensors (Sᵢ) for detecting the zero point of said magnetic field component (B_{Z}).

2. A sensor as claimed in Claim 1, characterized by the fact that said elementary sensors (Sᵢ) are Hall-effect sensors, each generating an electric signal proportional to the strength of said magnetic field component (B_{Z}).

3. A sensor as claimed in Claim 2, characterized by the fact that it comprises zero detecting means (10, 12; 25-27) having a number of inputs connected to said elementary sensors (Sᵢ), and generating an output signal indicating the position of one of said elementary sensors corresponding to said zero point of said magnetic field component (B_{Z}).

4. A sensor as claimed in Claim 3, characterized by the fact that said zero detecting means comprise position detecting means (10; 25) generating an output signal indicating the position of one of said elementary sensors (Sᵢ) generating an electric output signal opposite in sign to the electric signal generated by one of the two adjacent elementary sensors.

5. A sensor as claimed in Claim 3 or 4, characterized by the fact that said zero detecting means comprise a number of comparators (10), each connected to a respective elementary sensor (Sᵢ) and each having an output (11) supplying a respective logic signal indicating the sign of said magnetic field component (B_{Z}).

6. A sensor as claimed in Claim 5, characterized by the fact that it comprises an encoder circuit (12) connected to said outputs (11) of said comparators (10) and generating at the output (13) a quantized position signal coding the position of said magnetic element (5) in relation to said position sensor (1).

7. A sensor as claimed in Claim 3 or 4, characterized by the fact that said zero detecting means comprise a multiplexing element (26) having a number of inputs connected to said elementary sensors (Sᵢ), and an output; a comparator (25) having an input connected to said output of said multiplexing element; and a counter (27) connected to the output of said comparator.

8. A sensor as claimed in any one of the foregoing Claims from 2 to 7, characterized by the fact that said elementary sensors (Sᵢ) are solid-state sensors integrated adjacent to one another in a single chip (2) of semiconductor material.

9. A sensor as claimed in Claim 8, characterized by the fact that said elementary sensors (Sᵢ) are aligned in a flat line; and by the fact that each elementary sensor presents a pair of contacts (Cᵢ₋₁, Cᵢ).

10. A sensor as claimed in Claim 8, characterized by the fact that each contact (Cᵢ₋₁, Cᵢ) of one elementary sensor (Sᵢ) is connected to a contact of an adjacent elementary sensor (Sᵢ₋₁, Sᵢ₊₁).

11. A sensor as claimed in any one of the foregoing Claims from 1 to 10, characterized by the fact that it comprises a second plurality (32) of elementary sensors (S₁-Sₙ) extending close and parallel to, and offset in relation to said at least one plurality (31) of elementary sensors.

12. A position transducer-encoder for detecting the position of a magnetic element (5) generating a magnetic field having at least one component (B_{Z}) zeroing in at least one point in space; characterized by the fact that it comprises a plurality of side by side elementary sensors (Sᵢ) for detecting the zero point of said magnetic field component; and an encoder circuit (12, 27) connected to said elementary sensors and generating a coded output position signal indicating the position of one of said elementary sensors corresponding to said zero point of said magnetic field component.

13. A transducer-encoder as claimed in Claim 12, characterized by the fact that said encoder circuit comprises position detecting means generating an output signal indicating the position of one of said elementary sensors generating an electric output signal opposite in sign to the electric signal generated by one of the two adjacent elementary sensors.
